Europäisches Patentamt

European Patent Office

Office européen des brevets

(11) Publication number: **0 315 980 A2**

# (12) EUROPEAN PATENT APPLICATION

(21) Application number: **88118684.5**

(22) Date of filing: **09.11.88**

(51) Int. Cl.⁴: **H01L 23/52**

The title of the invention has been amended (Guidelines for Examination in the EPO, A-III, 7.3).

(30) Priority: **12.11.87 JP 284322/87**

(43) Date of publication of application:
**17.05.89 Bulletin 89/20**

(84) Designated Contracting States:
**DE FR GB**

(71) Applicant: **KABUSHIKI KAISHA TOSHIBA**
**72, Horikawa-cho Saiwai-ku**
**Kawasaki-shi Kanagawa-ken 210(JP)**

Applicant: **Toshiba Micro-Computer**
**Engineering Corporation**
**25-1, Ekimaehoncho Kawasaki-ku**
**Kawasaki-shi(JP)**

(72) Inventor: **Takahashi, Kazuhiko**
**106 Zoshiki-Mansion 2-15-3, Higashirokugo**
**Oota-ku Tokyo(JP)**
Inventor: **Segawa, Makoto c/o Patent Division**
**K.K. Toshiba**
**1-1 Shibaura 1-chome Minato-ku**
**Tokyo 105(JP)**
Inventor: **Kobayashi, Kiyoshi Patent Division**
**K.K. Toshiba**
**1-1 Shibaura 1-chome Minato-ku**
**Tokyo 105(JP)**
Inventor: **Ochii, Kiyofumi Patent Division K.K.**
**Toshiba**
**1-1 Shibaura 1-chome Minato-ku**
**Tokyo 105(JP)**

(74) Representative: **Henkel, Feiler, Hänzel &**
**Partner**
**Möhlstrasse 37**
**D-8000 München 80(DE)**

(54) Semiconductor device having conductive layers.

(57) A semiconductor device is of a three-layered structure comprising a first polycrystalline silicon layer (3) which is thick, a second polycrystalline silicon layer (5) which is thinner than the first polycrystalline silicon layer (3), and a metal wiring layer (4). As a result of this three-layered structure, the wiring area of the semiconductor device can be reduced. Moreover, even if the material of the metal wiring layer (4) flows through the second polycrystalline silicon layer in the heat treatment process of the manufacture of the semiconductor device, the thick first polycrystalline silicon layer blocks the flow of the material, with the result that defective wiring is not produced in the semiconductor device.

F I G. 3A

## Semiconductor device

The present invention relates to a semiconductor device wherein the connection between a polycrystalline silicon layer and a metal wiring layer is improved.

In the manufacturing of a semiconductor device which includes a polycrystalline silicon layer serving as a high-resistivity layer, it is required that the amount of impurities diffused in the polycrystalline silicon layer be as small as possible. In addition, it is required, from the point of view of miniaturization of the semiconductor device, that the polycrystalline silicon layer be as thin as possible.

A polycrystalline silicon layer used as a high-resistivity layer serves to electrically insulate a low-resistivity metal wiring layer (i.e., one which is formed of aluminum or other types of metal and is used as a wiring lead) from other conductive layers in the semiconductor device. However, if the polycrystalline silicon layer comes into physical contact with the lowresistivity metal wiring layer, the material of the metal wiring layer may penetrate through the polycrystalline silicon layer in a succeeding heat treatment, which is performed to obtain reliable contact between the respective layers of the semiconductor device, with the result that the polycrystalline silicon layer may be short-circuited to a conductive layer, resulting in defective wiring.

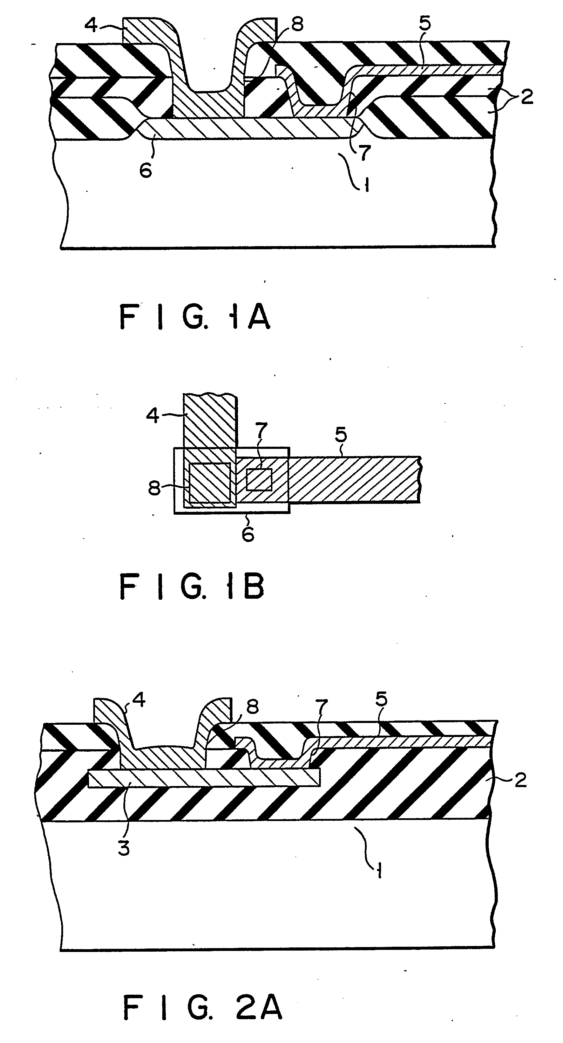

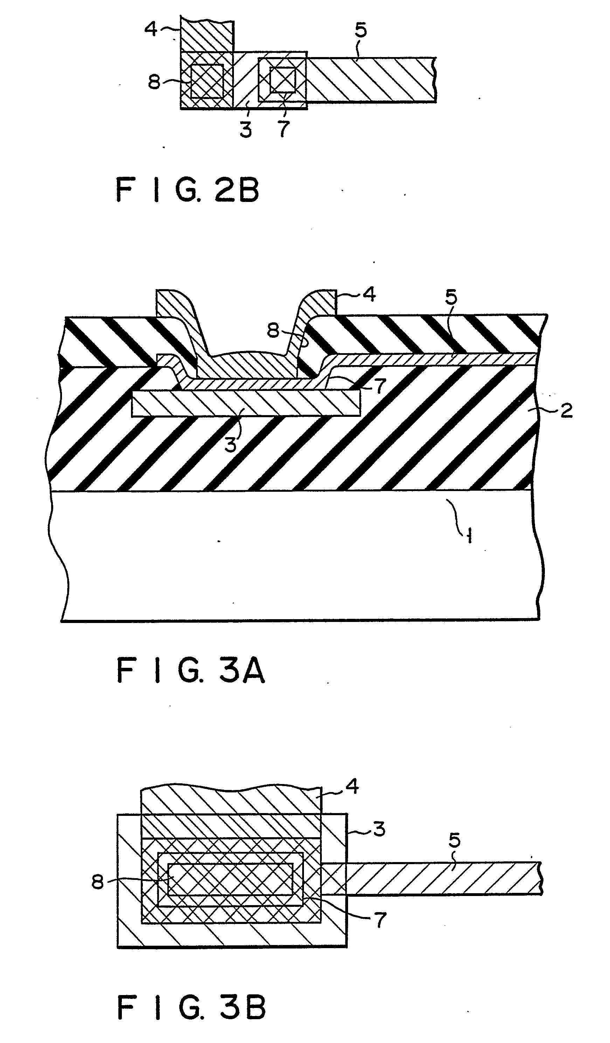

In order to avoid this problem, the prior art has made use of the construction illustrated in Figs. 1A and 1B or that illustrated in Figs. 2A and 2B, in the manufacture of such semiconductor devices. Referring to Fig. 1A, insulating layer 2, composed of silicon oxide or some other suitable material, is formed on silicon substrate 1. Then, first polycrystalline silicon layer 6, which contains impurities and is electrically conductive, and which is formed in the same step as that of the gate electrode of a MOS transistor, is formed within insulating layer 2. Contact holes 7 and 8 are formed in insulating layer 2, whereby the surface of first polycrystalline silicon layer 6 is partly exposed. Thereafter, metal wiring layer 4 (e.g., an aluminum wiring layer) and second polycrystalline silicon layer 5 (i.e., a high-resistivity layer) are formed such that they fill contact holes 8 and 7, respectively, and touch the exposed parts of the surface of first polycrystalline silicon layer 6. As a result, second polycrystalline silicon layer 5 and metal wiring layer 4 are electrically connected to each other through first polycrystalline silicon layer 6. Incidentally, Fig. 1B is a plan view of the construction shown in Fig. 1A.

The construction shown in Fig. 2A is similar to that shown in Fig. 1A, except that $n^+$-diffusion layer 3 is used in lieu of first polycrystalline silicon layer 6. Fig. 2B is a plan view of the construction shown in Fig. 2A.

In the construction illustrated in Figs 1A and 1B and in that illustrated in Figs. 2A and 2B, metal wiring layer 4 is not in physical contact with high-resistivity polycrystalline silicon layer 5. Since, therefore, metal wiring layer 4 does not penetrate through polycrystalline silicon layer 5 in the course of a subsequent heat treatment process, the incidence of defective wiring, likely to arise from such penetration, is substantially eliminated in the case of these conventional constructions. Nevertheless, the above constructions must still contend with another problem, which will be described below.

During the process of forming the above constructions, contact holes 7 and 8 are formed in insulating layer 2, in order to expose part of the surface of first polycrystalline silicon layer 6 (in the case of Figs. 1A and 1B, or, in the case of Figs. 2A and 2B, part of the surface of $n^+$-diffusion layer 3, after which holes 7 and 8 are filled with second polycrystalline silicon layer 5 and metal wiring layer 4, respectively. However, prior to holes 7 and 8 being filled, those parts of the surface of either first polycrystalline silicon layer 6 or n + -diffusion layer 3 which have been exposed to the surrounding atmosphere may, as a result of chemical reaction therewith, have become covered with a thin oxide film. Should such an oxide film be formed, this will result in an increase in the contact resistance between metal wiring layer 4 and first polycrystalline silicon layer 6 (or $n^+$-diffusion layer 3), as well as that between second polycrystalline silicon layer 5 and layer 6 (or $n^+$-diffusion layer 3).

The contact resistance can be prevented from increasing if contact holes 7 and 8 are filled with a barrier metal or the like before second polysilicon layer 5 and metal wiring layer 8 are electrically connected together. However, this cannot be done without increasing the number of manufacturing steps.

In the case of the above-mentioned conventional constructions, either first polycrystalline silicon layer 6 or $n^+$-diffusion layer 3 is employed for the electrical connection between second polycrystalline silicon layer 5 and metal wiring layer 4. Due to the use of layer 3 or 6, it is difficult to obtain a minute or fine semiconductor device.

Accordingly, the object of the present invention is to provide a semiconductor device, wherein a metal wiring layer and a high-resistivity polycrystalline silicon layer are in reliable electrical contact with each other and wherein the wiring area is decreased to the greatest extent possible.

To achieve this object, the present invention provides a semiconductor device, which comprises: a silicon substrate;

a first insulating layer located on a silicon substrate;

a first polycrystalline silicon layer formed within the first insulating layer, the first insulating layer having a first contact hole which exposes part of the surface of the first polycrystalline silicon layer;

a second polycrystalline silicon layer, formed on the first insulating layer and in the first contact hole, the second polycrystalline silicon layer being thinner than the first polycrystalline silicon layer;

a second insulating layer, formed on both the first insulating layer and the second polycrystalline silicon layer, the second insulating layer having a second contact hole which exposes part of the surface of that portion of the second polycrystalline silicon layer which is in contact with the first polycrystalline silicon layer; and

a metal wiring layer formed in the second contact hole and in contact with the second polycrystalline silicon layer.

In the semiconductor device of the present invention, the first polycrystalline silicon layer, the second polycrystalline silicon layer, and the metal wiring layer constitute a three-layered structure. Even if the metal constituting the metal wiring layer were to penetrate through the second polycrystalline silicon layer (which is thin), the above structure, whereby it the first polycrystalline silicon layer (which is thick) is located under the second polycrystalline silicon layer, ensures that the metal it will not extend into a diffusion layer or the silicon substrate.

This invention can be more fully understood from the following detailed description when taken in conjunction with the accompanying drawings, in which:

Figs. 1A and 1B are sectional and plan views, respectively, of a conventional semiconductor device;

Figs. 2A and 2B are sectional and plan views, respectively, of another conventional semiconductor device; and

Figs. 3A and 3B are sectional and plan views, respectively, of a semiconductor device according to the present invention.

An embodiment of the present invention will now be described, with reference to the accompanying drawings.

Fig. 3A is a sectional view of a semiconductor device embodying the present invention, and Fig. 3B is a plan view thereof. Referring first to Fig. 3A, first insulating layer 2, composed of silicon oxide, is formed on silicon substrate 1. Formed within first insulating layer 2 is first polycrystalline silicon layer 3, which is formed in the same step as that of the gate electrode of a MOS transistor and is thicker than second polycrystalline silicon layer 5, to be described later. Thereafter, contact hole 7 is formed in first insulating layer 2, thereby exposing part of the surface of first polycrystalline silicon layer 3, and second polycrystalline silicon layer 5, which constitutes a highresistivity wiring layer, is formed such that it is located both in first contact hole 7 and on first insulating layer 2.

Second insulating layer 10, composed of silicon oxide, is formed on both first insulating layer 2 and second polycrystalline silicon layer 5. Second contact hole 8 is formed in insulating layer 10 such that the surface of that portion of polycrystalline silicon layer 5 which is located on first polycrystalline silicon layer 3 is exposed.

Metal wiring layer 4, made of aluminum, is formed in second contact hole 8 and on that portion of second insulating layer 10 which surrounds contact hole 8, as a result of which, second polycrystalline silicon layer 5 and metal wiring layer 4 are electrically connected to each other. Incidentally, first polycrystalline silicon layer 3 may be replaced with a molybdenum layer.

During the manufacture of the above semiconductor device, first insulating layer 2 is partly etched out for the formation of first contact hole 7. Even if layer 2 is inadvertently over-etched, this does not constitute a serious problem, since first polycrystalline silicon layer 3 is sufficiently thick and serves as a barrier against etching.

The above advantage also applies in the case where second insulating layer 10 is to be partly etched out for the formation of second contact hole 8, with first polycrystalline silicon layer 3 again serving as a barrier against etching should insulating layer 10 be unintentionally over-etched to the level of second polycrystalline silicon layer 5.

When the heat treatment process is performed during the manufacture of the semiconductor device of the present invention, silicon particles move from second polycrystalline silicon layer 5 into metal wiring layer 4, leaving cavities in layer 5, which are then filled by the metal constituting metal wiring layer 4 flowing thereinto. This phenomenon is generally referred to as a "spike phenomenon." In the case of the prior art, the spike phenomenon results in defective wiring. In the case of the present invention, however, it does not result in defective wiring since polycrystalline silicon layer 3, located under second polycrystalline silicon layer 5, is so thick that the metal constituting metal wiring layer 4 does not penetrate through polycrystalline silicon layer 5. As a result, metal wiring layer 4 is prevented from touching some other conductive layer in the semiconductor device.

In the semiconductor device of the present invention, first polycrystalline silicon layer 3, second polycrystalline silicon layer 5, and metal wiring layer 4 constitute a three-layered structure. It should be noted that the contact area within this three-layered structure can remain constant before and after the spike phenomenon, for the reason below.

The contact area between metal wiring layer 4 and second polycrystalline silicon layer 5 is reduced as a result of the spike phenomenon. However, the metal penetrating through second polycrystalline silicon layer 5 contacts first polycrystalline silicon layer 3.

Therefore, the reduction in the contact area between metal wiring layer 4 and second polycrystalline silicon layer 5 is compensated for, due to the metal which contacts first polycrystalline silicon layer 3 after the spike phenomenon.

Moreover, the three-layred structure of the present invention enables reduction of the wiring area.

## Claims

1. A semiconductor substrate, wherein a high-resistivity wiring layer (5) is in contact with a metal wiring layer (4) and is used as a wiring lead, characterized by comprising:
a silicon substrate (1);
a first insulating layer (2) located on said silicon substrate (1);
a conductive layer (3) formed within said first insulating layer (2), said conductive layer (3) being thicker than said high-resistivity wiring layer (5);
a first contact hole (7) formed in said first insulating layer (2) to partly expose a surface of said conductive layer (3), said high-resistivity wiring layer (5) being formed on the first insulating layer (2), in the first contact hole (7), and on the exposed surface of said conductive layer (3);
a second insulating layer (10) formed on both said first insulating layer (2) and said high-resistivity wiring layer (5); and
a second contact hole (8) formed in said second insulating layer (10) to expose the surface of that portion of said high-resistivity wiring layer (5) which is located on said conductive layer (3), said metal wiring layer (4) being formed in said second contact hole and in contact with said high-resistivity wiring layer (5).

2. A semiconductor device according to claim 1, characterized in that said conductive layer (3) is formed of a wiring material including molybdenum, or polycrystalline silicon with which to form a gate electrode of an MOS transistor.

3. A semiconductor device according to claim 1, characterized in that said high-resistivity wiring layer (5) is formed of polycrystalline silicon.

4. A semiconductor device according to claim 1, characterized in that said metal wiring layer (4) is formed of aluminum.

F I G. 1A

F I G. 1B

F I G. 2A

EP 0 315 980 A2

F I G. 2B

F I G. 3A

F I G. 3B